# EUROPEAN PATENT SPECIFICATION

(11) **EP 0 279 943 B1**
(45) Date of publication and mention of the grant of the patent: **06.10.1993**
(21) Application number: 87118836.3
(22) Date of filing: 11.07.1983
(51) Int. Cl.: H03K 19/01, H03K 19/094, H01L 27/06

(54) **Gate circuit of combined field-effect and bipolar transistors**
Torschaltung mit Feldeffekt- und Bipolartransistoren
Circuit porte utilisant des transistors à effet de champ et des transistors bipolaires

(30) Priority: 12.07.1982 JP 119815/82
(43) Date of publication of application: 31.08.1988
(62) Divisional of application: 83106796.2
(73) Proprietor: HITACHI, LTD., Chiyoda-ku, Tokyo 101 (JP)
(72) Inventor: Masuda, Ikuro, Hitachi-shi (JP); Kato, Kazuo, Naka-gun Ibaraki-ken (JP); Sasayama, Takao, Hitachi-shi (JP); Nishio, Yoji, Hitachi-shi (JP); Kuboki, Shigeo, Nakaminato-shi (JP); Iwamura, Masahiro, Hitachi-shi (JP)
(74) Representative: Beetz & Partner Patentanwälte

(56) References cited:
- FR-A- 2 449 334
- US-A- 425 877
- US-A- 3 541 353
- IEEE TRANSACTIONS ON ELECTRON DEVICES, vol. ED-16, no. 11, November 1969, pages945-951; H.C. LIN et al.: "Complementary MOS-bipolar transistor structure"
- IBM TECHNICAL DISCLOSURE BULLETIN, vol. 16, no. 11, April 1974, pages 3570-3571; W.B. CHIN et al.: "Push-pull driver using bipolar and complementary metal-oxyde semiconductor devices"
- PATENT ABSTRACTS OF JAPAN, vol. 4, no. 79 (E-14), 7th June 1980, page 27 E 14; & JP - A - 55 45259
- PATENT ABSTRACTS OF JAPAN, vol. 4, no. 59 (E-9), 2nd May 1980, page 9 E 9; & JP - A - 55 27790
- PATENT ABSTRACTS OF JAPAN, vol. 2, no. 120 (E-78), 6th October 1978, page 6968 E 78; & JP - A - 53 86151
- PATENT ABSTRACTS OF JAPAN, vol. 4, no. 1 (E-163), 8th January 1980, page 116 E 163; & JP - A - 54 142 061
- PATENT ABSTRACTS OF JAPAN, vol. 4, no. 8 (E-166), 22nd January 1980, page 103 E 166; & JP - A - 54 148 469

## Description

This invention relates to gate circuits formed of a combination of field-effect transistors and bipolar transistors.

There is known a gate circuit formed of a combination of field-effect transistors and bipolar transistors so as to achieve high-speed operation and low-power consumption, for example, an inverter circuit shown in Fig. 1 (See JP-A-54-148469).

This inverter circuit is formed of a P-channel metal (silicon)-oxide-semiconductor field-effect-transistor (hereinafter referred to simply as PMOS) 50, an N-channel metal (silicon)-oxide-semiconductor field-effect-transistor (hereinafter referred to simply as NMOS) 51, an NPN-transistor 53, and a PNP transistor 54.

In this inverter circuit, when the input 55 is at "0" level, the PMOS 50 is turned on but the NMOS 51 off. Consequently, the base potential of the NPN transistor 53 and the PNP transistor 54 is increased to turn on the NPN transistor 53 but turn off the PNP transistor 54, and thus the output 56 becomes "1" level. When the input 55 is at "1" level, the PMOS 50 is turned off but the NMOS 51 on. Consequently, the base potential of the NPN transistor 53 and the PNP transistor 54 is reduced to turn off the NPN transistor 53 but turn on the PNP transistor 54, and thus the output 56 becomes "0" level.

However, since the bipolar transistors 53 and 54 used are complementary and difficult to be matched in their switching characteristics, the trailing edge of the output signal 56 is delayed. This is because the PNP transistor of the complementary transistors is inferior in its performances such as current amplification factor to the NPN transistor.

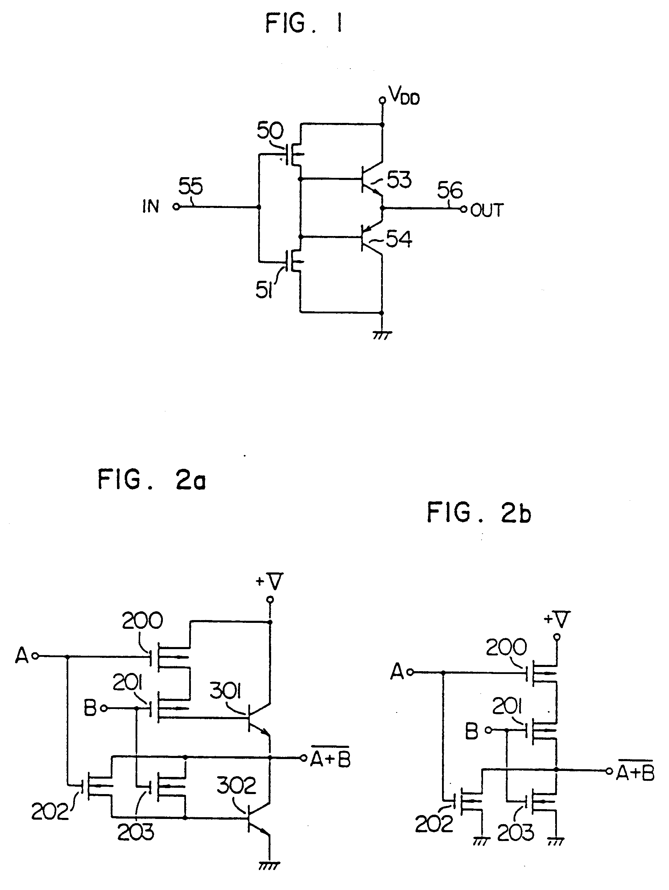

There is also known a 2-input NOR gate circuit shown in Fig. 2a (IEEE. Trans. Electron Devices, vol. ED-16, No. 11, pp. 945-951, Nov. 1969). This 2-input NOR circuit is a combination of a C-MOS transistor NOR gate circuit having PMOSs 200 and 201 and NMOSs 202 and 203 as shown in Fig. 2b, and NPN transistors 301 and 302. In this 2-input NOR gate circuit, when the NPN transistors 301 and 302 are turned off from the ON-state, the time required for the switching from the ON-state to the OFF-state is long because here are no means for forcibly extracting or drawing out minority charges accumulated on the bases of the NPN transistors 301 and 302. Thus, the first and second NPN transistors 301 and 302 remain long in the ON-state, so that the switching time as well as the power consumption increase.

US-A-4 225 877 discloses an integrated circuit with C-MOS logic and a bipolar driver with polysilicon resistors. However, the structure of the semiconductor devices such as feed-transistors FET-transistors and bipolar transistors disclosed in this document is not sufficient to enable low power and high frequency switching properties of the circuit. This results from the fact that the bipolar transistors are not isolated from other semiconductor devices, thus increasing power consumption. Moreover, the structure is related to another circuit as compared to that of the present invention.

The French document FR-A-2 449 334 discloses a method for monolithic integration of circuits. It discloses general considerations of how a monolithic integrated circuit has to be fabricated. As examples a driving circuit for a plasma display and a programmable current source are given.

It is the object of the present invention to provide a BiCMOS integrated circuit device which provides high-speed operation and high packing density and which has a low power consumption.

This object is solved in accordance with the features of Claim 1. The dependent claims relate to preferred embodiments of the present invention.

According to one embodiment, the gate circuit according to the invention is integrated in a semiconductor substrate having a first and a second main surface. All electrodes of gates, drains, sources, collectors, emitters, bases and of the discharge means are formed on the first main surface.

The invention will be explained with reference to preferred embodiments and the accompanying drawings, wherein for a better understanding and because of the relation between the parent patent and the present subject-matter concerning the claim features A) to H) reference is also made to the subject-matter of the parent patent, because the concept of this invention can be applied to the circuit principle according to the parent patent.
Fig. 3 is a circuit diagram showing a logic gate circuit in the form of an inverter according to the parent patent;
Fig. 4 is a schematic diagram showing a cross-section of the logic gate circuit of Fig. 3, implemented in an integrated circuit structure according to this invention;
Figs. 5 - 7 are circuit diagrams showing NAND, NOR and latch circuits, respectively, according to the parent patent;
Figs. 8 - 10 are circuit diagrams showing inverter circuits according to the parent patent;
Figs. 11 - 13 are circuit diagrams of inverter circuits according to different embodiments of this invention; and
Figs. 14 - 16 are circuit diagrams of inverter NAND and NOR circuits, respectively, according to the parent patent.

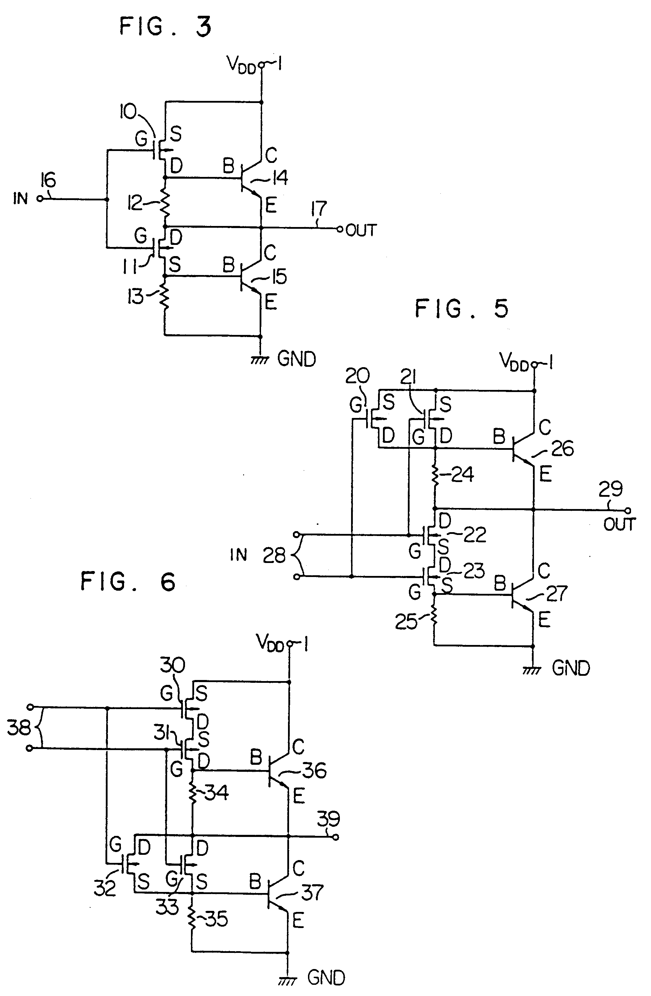

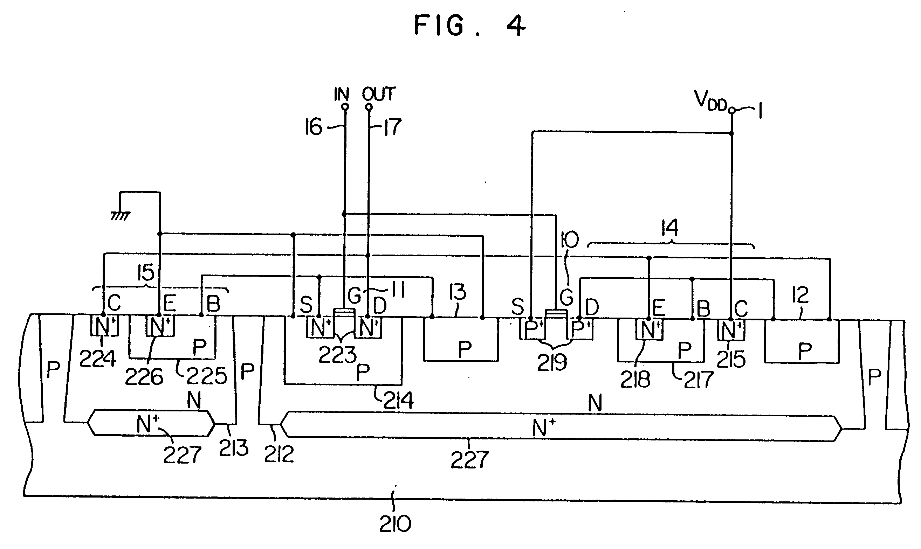

The inverter circuit shown in Fig. 3 comprises a first bipolar NPN transistor 14 having its collector electrode C connected to a power supply terminal 1 at which a first fixed potential V_{DD} is maintained, and its emitter electrode E connected to an output terminal 17. The collector electrode C of a second bipolar NPN transistor 15 is connected to the output terminal 17 and its emitter electrode E connected to ground potential GND as a second fixed potential. The gate electrode G of a P-channel metal (silicon)-oxide-semiconductor field-effect-transistor (hereinafter, referred to simply as PMOS) 10 is connected to an input terminal 16, its source electrode S and its drain electrode D being respectively connected to the collector electrode C and the base electrode B of the first NPN transistor 14. Furthermore, the circuit comprises an N-channel metal (silicon)-oxide-semiconductor field-effect transistor (hereinafter, referred to simply as NMOS) 11 having its gate electrode G connected to the input terminal 16, and its drain electrode D and source electrode S respectively connected to the collector electrode C and the base electrode B of the second NPN transistor 15. A resistor 12 connects the drain electrode D of the PMOS 10 with the drain electrode D of the NMOS 11, and the resistor 13 connects the base electrode B with the emitter electrode E of the second NPN transistor 15.

Fig. 4 schematically shows the cross-section of the implementation of the inverter circuit illustrated in Fig. 3 in a semiconductor integrated circuit structure according to the invention. The PMOS 10, the first NPN transistor 14, resistors 12 and 13 and the NMOS 11 are formed in an island 212 of a semiconductor substrate 210, and the second NPN transistor 15 in an island 213 thereof.

Below these transistor structures a buried layer 227 is provided. A P⁺-region 219 and a gate electrode G constitute the PMOS 10, and an N⁺-region 223 and a gate electrode G within a P well 214 constitute the NMOS 11. The first NPN transistor 14 comprises a P-region 217 as its base, and N⁺-region 218 within the P-region 217 as its emitter and an N⁺-region 215 as its collector. The second NPN transistor 15 comprises a P-region 225 within the island 213 as its base, an N⁺-region 226 within the P-region 225 as its emitter, and an N⁺-region 224 as its collector. The corresponding electrodes of the NPN transistors 14 and 15 are designated with B, E and C, respectively.

In table 1 the logic operation of the inverter circuit of this embodiment are indicated.

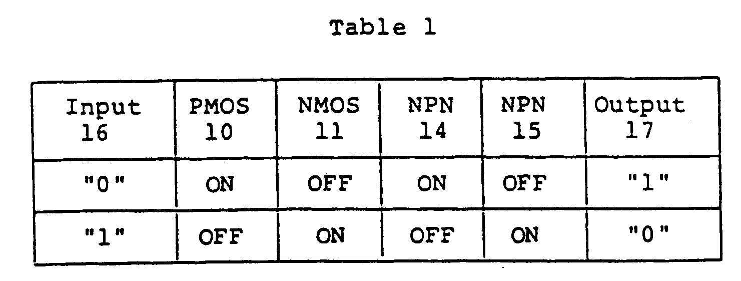

When the input terminal 16 is at "0" level, the PMOS 10 is turned on but the NMOS 11 off. Thus, the base potential of the first NPN transistor 14 increases to turn on the NPN transistor 14. At this time, since the NMOS 11 is turned off, the current to the second NPN transistor 15 is stopped, and the charges accumulated in the base B of the second NPN transistor 15 are drawn out through the resistor 13 to the ground, so that the second NPN transistor 15 is rapidly turned off.

Therefore, the emitter current of the first NPN transistor 14 charges the load (not shown), and the output terminal 17 rapidly becomes "1" level.

When the input terminal 16 is at "1" level, the PMOS 10 is made off but the NMOS 11 on. At this time, since the PMOS 10 is off, the current to the NPN transistor 14 stops, and the charges stored on the base of the first NPN transistor 14 and in the drain of the PMOS 10 are drawn out through the resistors 12 and 13 to the ground, so that the first NPN transistor 14 is rapidly turned off. In addition, since the NMOS 11 is on to form a short-circuit between its drain electrode D and its source electrode S, the second NPN transistor 15 is supplied at its base electrode B with the current from the output terminal 17 and with the charges stored in the base of the first NPN transistor 14 and in the drain of the PMOS 10 as mentioned above, and thereby the NPN transistor 15 is rapidly turned on. Consequently, the output terminal 17 rapidly reaches "0" level.

The function of the resistor 12 will further be described. When the PMOS 10 and the first NPN transistor 14 are switched from the ON-state to the OFF-state, the resistor 12 extracts the charges accumulated in the drain of the PMOS 10 and in the base of the first NPN transistor 14 to rapidly turn off the first NPN transistor 14, and supplies the extracted charges via the NMOS 11 in the ON-state to the base electrode B of the second NPN transistor 15 to rapidly turn on the second NPN transistor 15.

In addition, since the resistor 12 is provided between the drain of the PMOS 10 and the drain of the NMOS 11, a conductive path for causing short-circuiting is not formed between the power supply terminal 1 and GND, and thus low-power consumption in the C-MOS circuit can be achieved. In other words, if the resistor 12 were connected between the drain of the PMOS 10 and GND, a conductive path would be formed between the power supply terminal 1 and GND when the input terminal 16 is at "0" level, and thus current would always flow therethrough to increase power consumption.

Moreover, in this embodiment, since the resistor 12 is also connected to the output terminal 17, the potential at the output terminal 17, when the input terminal 16 is at "0" level, can be raised to the potential at the power supply terminal 1 through the PMOS 10 and the resistor 12, thus assuring enough noise immunity.

The function of the resistor 13 will hereinafter be described. As mentioned before, the resistor 13, when the NMOS 11 and the second NPN transistor 15 are switched from the ON-state to the OFF-state, discharges the charges accumulated in the base of the second NPN transistor 15 so as to rapidly turn off the second NPN transistor 15. Also, in this embodiment, when the input terminal 16 is at "1" level, the output terminal 17 can be brought to "0" level through the resistor 13 and the NMOS 11, thus assuring enough noise immunity.

Moreover, in this embodiment, the bipolar transistors used are of the same NPN-type, which is advantageous for obtaining uniform switching characteristics.

Furthermore, in this embodiment, since no PNP transistor with low current amplification is used, the output signal shows no trailing effect, and thus high-speed operation is ensured.

Fig. 5 shows a 2-input NAND circuit according to the parent patent to which this invention can be applied. This circuit comprises a first NPN transistor 26 having its collector electrode C connected to the power supply terminal 1, and its emitter electrode E connected to an output terminal 29, a second NPN transistor 27 having its collector electrode C connected to an output terminal 29 and its emitter electrode E connected to ground potential GND, and two input terminals 28. In addition, the gate electrodes G of PMOSs 20 and 21 are respectively connected to one and the other of the input terminals 28, their source - drain paths being connected in parallel between the collector electrode C and the base electrode B of the first NPN transistor 26; the gate electrodes G of NMOSs 22 and 23 are respectively connected to one and the other of the input terminals 28, and their drain - source paths are connected in series between the collector electrode C and the base electrode B of the second NPN transistor 27. A resistor 24 is connected between the common drain of the PMOSs 20 and 21 and the drain of the NMOS 22, and a resistor 25 is connected between the base and the emitter of the second NPN transistor 27.

Table 2 shows the logic operation of this embodiment.

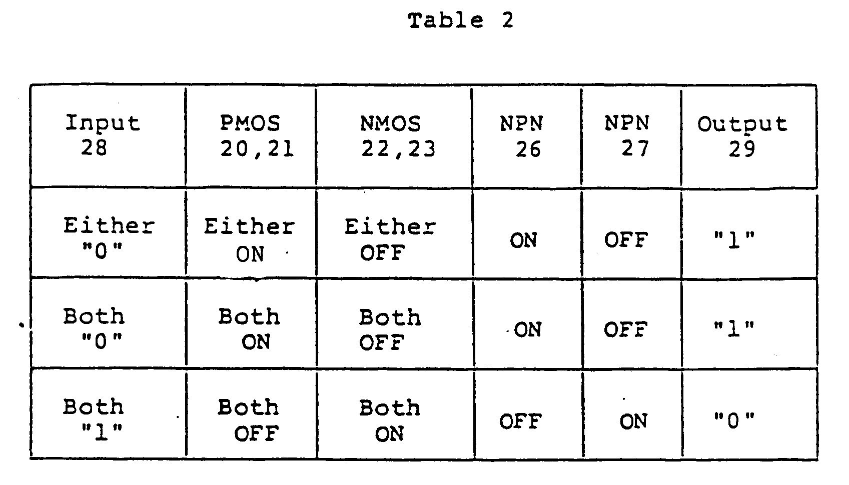

First, when either one of the input terminals 28 is at "0" level, either one of the PMOSs 20 and 21 is turned on, and either one of the NMOSs 22 and 23 is turned off. Thus, the base potential of the first NPN transistor 26 increases, and thus the NPN transistor 26 is turned on. At this time, since either one of the NMOS 22 and 23 is turned off, the current to the second NPN 27 is stopped, and the charges accumulated in the base of the second NPN transistor 27 are extracted, so that it is rapidly turned off.

Therefore, the emitter current of the first NPN transistor 26 charges the load to rapidly raise the potential of the output terminal 29 to "1" level.

When both of the input terminals 28 are at "0" level, both the PMOSs 20 and 21 are turned on, and both the NMOSs 22 and 23 are turned off. Thus, the operation is the same as above, the output terminal 29 reaching "1" level.

On the other hand, if both the input terminals 28 are at "1" level, both of the PMOSs 20 and 21 are turned off, and both NMOSs 22 and 23 are turned on. At this time, since both the PMOSs 20 and 21 are turned off, the current to the first NPN 26 stops flowing, and the charges accumulated in the base of the first NPN transistor 26 are extracted, so that it is rapidly turned off. Also, since the NMOSs 22 and 23 are turned on to form short-circuit-between the drains and sources the second NPN transistor 27 is supplied at its base electrode B with the current from the output terminal 29 and with discharge current from the base electrode B of the first NPN transistor 26 as described previously so as to rapidly turn it on. Thus, the output terminal 29 rapidly reaches "0" level.

While a 2-input NAND circuit is described in this embodiment this conception can also be applied to 3-input, 4-input and generally k-input NAND circuits (k ≧ 2) according to this invention.

Fig. 6 shows a 2-input NOR circuit according to the parent patent to which this invention can be applied.

This circuit comprises a first NPN transistor 36 having its collector electrode C connected to the power supply terminal 1 and its emitter electrode E connected to the output terminal 39, and a second NPN transistor 37 having its collector electrode C connected to the output terminal 39 and its emitter electrode E connected to ground potential GND. The gate electrodes G of two PMOSs 30 and 31 are connected to one and the other of the input terminals 38 and their source - drain paths connected in series between the collector electrode C and the base electrode B of the first NPN transistor 36. In addition, NMOSs 32 and 33 have their gate electrodes G connected to one and the other of the input terminals 38 and the drain - source paths connected in parallel between the collector electrode C and the base electrode B of the second NPN transistor 37. A resistor 34 connects the drain electrode D of the PMOS 31 with the drain electrodes D of the NMOSs 32 and 33, and a resistor 35 connects the base electrode B to the emitter electrode E of the second NPN transistor 37.

Table 3 shows the logic operation of this circuit.

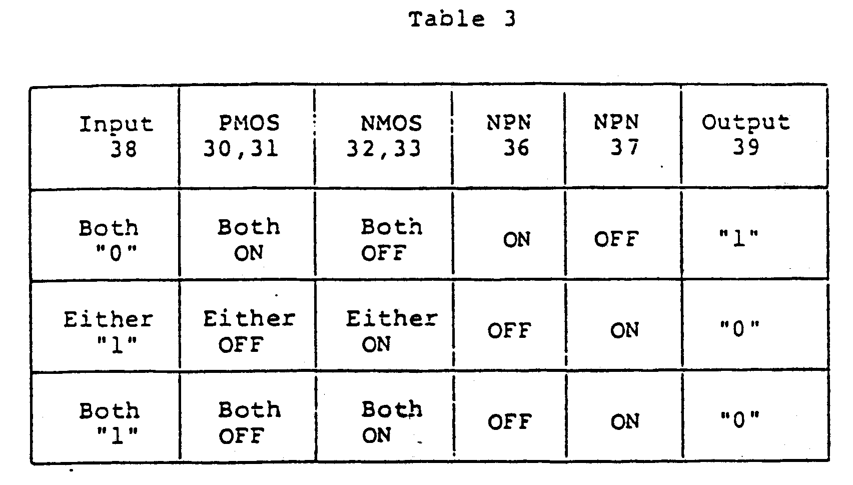

First, when both of the input terminals 38 are at "0" level, both the PMOSs 30 and 31 are turned on, and both the NMOSs 32 and 33 are turned off. Thus, the base potential of the first NPN transistor 36 increases, and as a result the NPN transistor 36 is turned on. At this time, since both the NMOSs 32 and 33 are turned off, the current to the second NPN transistor 37 stops flowing, and the charges accumulated in the base of the second NPN transistor 37 are extracted, so that it is rapidly turned off.

Therefore, the emitter current of the first NPN transistor 36 charges the load to rapidly raise the output terminal 39 to "1" level.

When either of the input terminals 38 is at "1" level, either of the PMOSs 30 and 31 is turned off, and either of the NMOSs 32 and 33 is turned on. At this time, since either of the PMOSs 30 and 31 is turned off, the current to the first NPN transistor 36 stops flowing, and the charges accumulated in the base of the first NPN transistor 36 are extracted, so that this transistor is rapidly turned off. In addition, since either of the NMOSs 32 and 33 is turned on to form short-circuit between the drains and the sources the second NPN transistor 37 is supplied at its base electrode B with the current from the output terminal 39 and with the current of the charges accumulated in the base of the first NPN transistor 36 and in either of the PMOSs 30 and 31, thus rapidly turning it on. Therefore, the output terminal 39 rapidly raises to "0" level.

When both input terminals 38 are at "1" level, both the PMOSs 30 and 31 are turned off, and both the NMOSs 32 and 33 are turned on. Consequently, the operation is the same as above, the output terminal 39 being at "0" level.

While a 2-input NOR circuit is described in this embodiment, this conception can also be applied to 3-input, 4-input and generally k-input NOR circuits (k ≧ 2) which may be designed according to this invention.

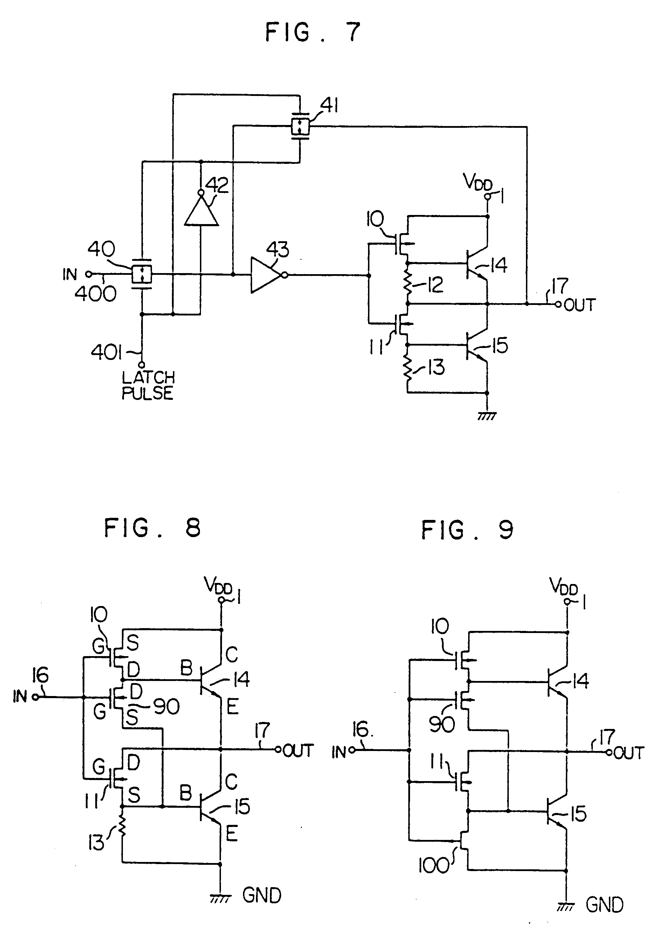

As an example for an application, Fig. 7 shows a latch circuit using at its output the inverter circuit shown in Fig. 3.

The circuit of Fig. 7 comprises a CMOS inverter 42 for reversing a latch pulse provided at terminal 401, a transfer gate 40 for transmitting data from the data input 400, a CMOS inverter 43 constituting a memory portion, and a transfer gate 41. Like elements corresponding to those of Fig. 3 are identified by the same reference numerals.

In order to latch the data from the data input 400, the latch pulse at terminal 401 is made "1". Then, the transfer gate 40 is turned on, and the transfer gate 41 is turned off, so that the data are written. Thereafter, when the latch pulse is made "0", the transfer gate 40 is turned off, and the transfer gate 41 is turned on. Consequently, the data are held by the inverter 43, the totem pole output type inverter and the transfer gate 41.

According to this embodiment, the latch circuit can be formed by the smallest configuration of a CMOS drive stage and two bipolar output stages as a high-speed, low-power consumption and high-density LSI.

Fig. 8 shows an inverter circuit according to the parent patent to which this invention can be applied.

In this embodiment, the resistor 12 shown in the embodiment of Fig. 3 is replaced by a second N-channel metal (silicon)-oxide-semiconductor field-effect transistor 90 (hereinafter, simply referred to as second NMOS 90), the NMOS 11 being the first NMOS. The second NMOS 90 has its gate electrode G connected to the input terminal 16, and its drain electrode D and its source electrode S connected to the drain electrode D of the PMOS 10 and the base electrode B of the second NPN transistor 15, respectively. Like elements corresponding to those of Fig. 3 are identified by the same reference numerals. The operation of the inverter of Fig. 8 is substantially the same as in the case of Fig. 3.

The circuit of Fig. 8 is different from that of Fig. 3 in that when the first NPN transistor 14 is turned off, or when the input terminal 16 is at "1" level, the second NMOS 90 is turned on, to discharge the charges accumulated in the first NPN transistor 14. Although in Fig. 3 the resistor 12 operates for this purpose, in this embodiment, the source electrode S of the second NMOS 90 is connected to the base electrode B of the second NPN transistor 15 so that the base current is increased to accelerate the switsching of the second NPN transistor 15 from the OFF-state to the ON-state. The source electrode S of the second NMOS 90 may be connected to the drain electrode D of the first NMOS 11.

In the first embodiment of Fig. 3 the current flows through the resistor 12 when the PMOS 10 is switched from the OFF-state to the ON-state, to delay the rise of the base potential of the first NPN transistor 14, and thus to somewhat delay the switching of the first NPN transistor 14 from the OFF-state to the ON-state, but in this embodiment when the PMOS 10 is turned on from the OFF-state the second NMOS 90 is turned off from the ON-state so that no current flows between drain and source of the NMOS 90. As a result, the base potential of the first NPN transistor 14 rises faster than in the first embodiment, to accelerate the switching of the NPN transistor 14 from the OFF- to the ON-state.

According to this embodiment, the second NMOS 90 is used in place of the resistor 12, so as to improve the integration density and the operation speed. Since the source S of the second NMOS 90 is connected to the base of the second NPN transistor 15, the operation speed is further improved.

Fig. 9 shows an inverter circuit according to the parent patent to which this invention can be applied.

In this embodiment, the resistor 13 of the circuit of Fig. 8 is replaced by a P-channel junction field-effect transistor (hereinafter, referred to as PJFET) 100 as a second P-channel field-effect transistor. The gate of the PJFET 100 is connected to the input terminal 16, and the source and the drain thereof are connected to the base and to the emitter of the second NPN transistor 15, respectively.

In Fig. 9, like elements corresponding to those of Figs. 3 and 8 are identified by the same reference numerals.

The embodiment of Fig. 9 is different from the circuit of Fig. 8 in that when the second NPN transistor 15 is turned off from the ON-state, or when the input terminal 16 is changed from level "1" to "0" level, the charges accumulated in the second NPN transistor 15 are extracted through the PJFET 100. When the charges are discharged, the ON-resistance of the PJFET 100 is decreased to accelerate the switching of the second NPN transistor 15 from the ON-state to the OFF-state. When the input terminal 16 changes from "0" to "1" level, the PJFET 100 is changed rom the ON-state to the OFF-state, and thus the base current to the second NPN transistor 15 is not shunted so that the second NPN transistor 15 is rapidly turned on from the OFF-state.

This embodiment provides a much higher speed as compared with the previously described embodiments.

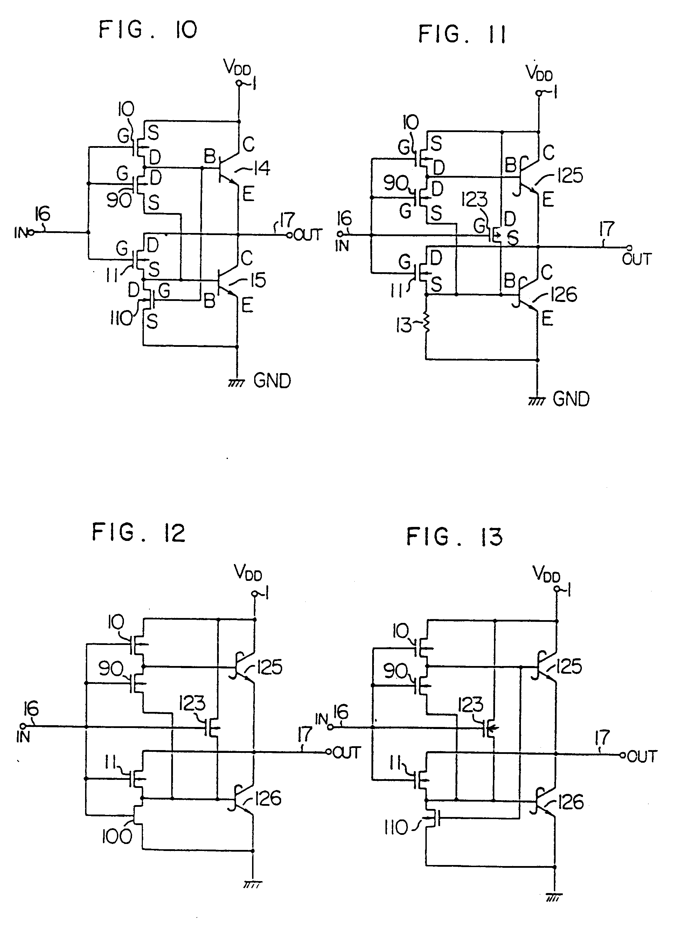

Fig. 10 shows an inverter circuit according to the parent application to which this invention can be applied.

In this embodiment, the resistor 13 in the circuit of Fig. 8 is replaced by a third N-channel metal oxide-semiconductor field-effect-transistor (hereinafter, referred simply as to third NMOS) 110. In Fig. 10, like elements corresponding to those of Figs. 3 and 8 are identified by the same reference numerals. The third NMOS 110 has its gate electrode G connected to the base electrode B of the first NPN transistor 14, and its drain electrode D and its source electrode S connected to the base electrode B and the emitter electrode E of the second NPN transistor 15, respectively.

This embodiment is different from the circuit of Fig. 8 in that when the second NPN transistor 15 is turned off from the ON-state, or when the input terminal 16 is changed from "1" to "0" level, the charges accumulated in the second NPN transistor 15 are extracted through the third NMOS 110. When the input terminal 16 is at "0" level, the high base potential of the first NPN transistor 14 is applied to the gate of the third NMOS 110, which then turns on to form short circuit between the base and emitter of the second NPN transistor 15, thus extracting the accumulated charges more rapidly.

According to this embodiment, since no resistor is used, a higher integration density can be achieved.

While some modifications of the inverter circuit of Fig. 3 are shown in Figs. 8, 9 and 10, this circuit conception can similarly be applied to multi-input NANDs such as in Fig. 5, multi-input NORs such as in Fig. 6 and latch circuits such as in Fig. 7.

The above described logic circuits can be used for implementation in LSIs according to this invention, which in turn can be applied to output buffer circuits for driving an external circuit. Examples of such applications are shown in Figs. 11, 12 and 13. Although these three examples are inverter circuits, the buffer circuit may also be a multi-input NAND or a multi-input NOR circuit.

Fig. 11 shows an inverter circuit according to a first embodiment of this invention. This circuit has substantially the same construction and operates in a similar manner as the circuit of Fig. 8.

In Fig. 11, like elements corresponding to those of Fig. 8 are identified by the same reference numerals. The circuit comprises a first NPN transistor 125 with a Schottky barrier diode provided between the base and collector as compared with the first NPN transistor 14 in Fig. 8, a second NPN transistor 126 with a Schottky barrier diode provided between the base and collector as compared with the second NPN transistor 15 of Fig. 8, and a fourth N-channel metal (silicon)-oxide-semiconductor field-effect-transistor (hereinafter, simply referred to as fourth NMOS) 123 having its gate electrode G connected to the input terminal 16 and its drain electrode D and its source electrode S respectively connected to the power supply terminal 1 and the base electrode B of the second NPN transistor 126.

This embodiment is different from the circuit of Fig. 8 in that the first and second NPNs 125 and 126, respectively, have a Schottky barrier diode added for the purpose of accelerating the time of extraction of accumulated charges, due to the saturation of the NPN transistors.

In addition, this embodiment is different from the circuit of Fig. 8 in that according to the invention the fourth NMOS 123 is provided between the power supply terminal 1 and the base electrode B of the second NPN transistor 126, with its gate electrode G being connected to the input terminal 16. This is because in the case of an output circuit, a sink current I_{OL} needs to be drawn in at a low-level output V_{OL}, and hence the second NPN 126 must be continuously supplied at its base with current at "1" level of the input terminal 16.

According to this embodiment of this invention, a high-speed, low-power consumption inverting output circuit can be realized.

Fig. 12 shows an inverter circuit according to a second embodiment of this invention. This circuit has substantially the same construction and operates in a similar manner as the circuit of Fig. 9.

In Fig. 12, like elements corresponding to those of Figs. 9 and 11 are identified by the same reference numerals. The resistor 13 in Fig. 11 is replaced by a PJFET 100 as in Fig. 9. This circuit is different from the circuit of Fig. 9 in that, as in the embodiment of Fig. 11, the first and second NPN transistors 125 and 126 have a Schottky barrier diode added, and in that the fourth NMOS 123 is provided for supplying current to the base of the second NPN transistor 126. According to this embodiment, an inverting output circuit operating at a much higher-speed can be realized.

Fig. 13 shows an inverter circuit of a third embodiment of this invention. This circuit has substantially the same construction and operates in a similar manner as the circuit of Fig. 10. In Fig. 13, like elements corresponding to those of Figs. 10 and 11 are identified by the same reference numerals. The resistor 13 in the circuit of Fig. 11 is replaced by the third NMOS 110. This embodiment is different from the circuit of Fig. 10 in that as in the first embodiment of Fig. 11, the first and second NPN transistors 125 and 126 have a Schottky barrier diode added, and in that the fourth NMOS 123 is provided for supplying current to the base of the second NPN transistor 126. According to this embodiment, inverting output circuits having a much higher integration density can be realized.

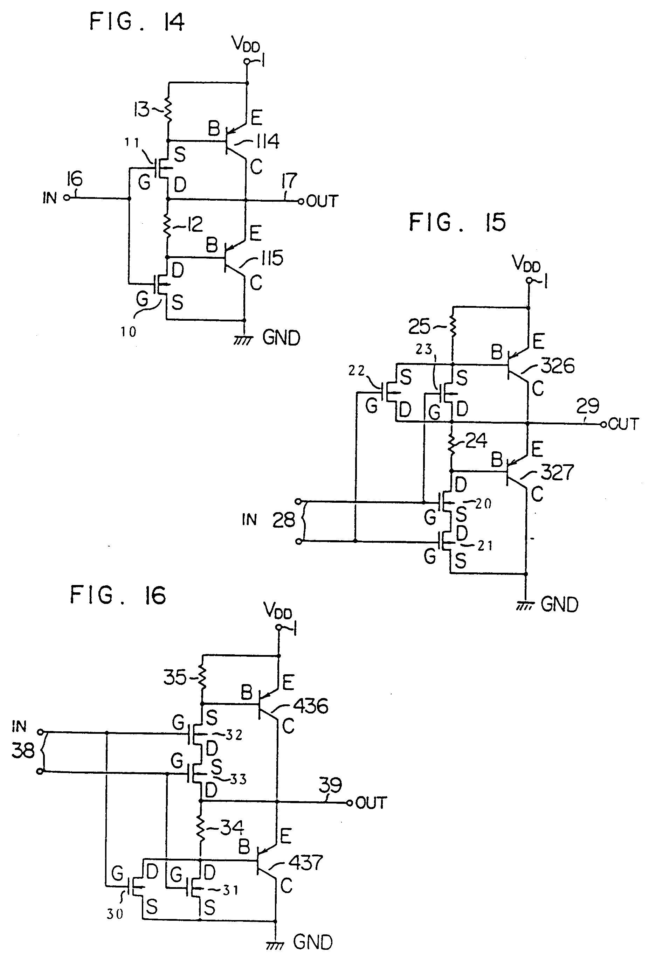

Fig. 14 shows an inverter circuit according to the parent patent to which this invention can be applied. This circuit comprises a bipolar PNP transistor (hereinafter, simply referred to as second PNP) 114 having its emitter electrode E connected to the power supply terminal 1 at which the fixed potential is kept, and its collector electrode C connected to the output terminal 17, and bipolar PNP transistor (hereinafter, simply referred to as first PNP) 115 having its emitter electrode E connected to the output terminal 17 and its collector electrode C connected to a fixed ground potential GND. The PMOS 11 has its gate electrode G connected to the input terminal 16, and its source electrode S and its drain electrode D respectively connected to the base electrode B and the collector electrode C of the second PNP transistor 114. The NMOS 10 has its gate electrode G connected to the input terminal 16 and its drain electrode D and its source electrode S respectively connected to the base electrode B and the collector electrode C of the first PNP transistor 115. The resistor 12 connects the drain electrode D of the PMOS 11 to that of the NMOS 10. The resistor 13 connects the base electrode B to the emitter electrode E of the second PNP transistor 114.

In this embodiment, the bipolar NPN transistors 14 and 15 of the circuit of Fig. 3 are replaced by the bipolar PNP transistors 115 and 114, respectively, whereby the same operation is performed.

Fig. 15 shows a 2-input NAND circuit according to the parent patent to which this invention can be applied. This circuit comprises a second PNP transistor 326 having its emitter electrode E connected to the power supply terminal 1 and its collector electrode C connected to the output terminal 29, a first PNP transistor 327 having its emitter electrode E connected to the output terminal 29 and its collector electrode C connected to the ground potential GND, two input terminals 28, and PMOSs 22 and 23 having their gate electrodes G connected to one and the other of the input terminals 28, respectively, and their source-drain paths connected in parallel between the base electrode B and the collector electrode C of the second PNP transistor 326. In addition, it comprises NMOSs 20 and 21 having their gate electrodes G respectively connected to one and the other of the input terminals 28 and their drain-source paths connected in series between the base electrode B and the collector electrode C of the first PNP transistor 327, a resistor 24 connecting the drain electrode D of the PMOSs 22 and 23 with the drain electrode D of the NMOS 20, and a resistor 25 connecting the base electrode B and the emitter electrode E of the second PNP transistor 326.

In this circuit, the bipolar NPN transistors 26 and 27 in the circuit of Fig. 5 are replaced by the bipolar PNP transistors 327 and 326, respectively, whereby the same operation as in this embodiment is performed.

While a 2-input NAND circuit is described in this embodiment, this conception can also be applied to 3-input, 4-input or generally k-input NAND circuits (k ≧ 2), to which this invention is applicable.

Fig. 16 shows a 2-input NOR circuit according to the parent patent to which this invention can be applied.

The circuit comprises a second PNP transistor 436 having its emitter electrode E connected to the power supply terminal 1 and its collector electrode C connected to the output terminal 39, a first PNP transistor 437 having its emitter electrode E connected to the output terminal 39 and its collector electrode C connected to the ground potential GND, two input terminals 38, PMOSs 32 and 33 having their gate electrodes G connected to one and the other of the input terminals 38, respectively, and their source-drain paths connected in series between the base electrode B and the collector electrode C of the second PNP transistor 436, and NMOSs 30 and 31 having their gate electrodes G connected to one and the other of the input terminals 38, respectively, and their drain-source paths connected in parallel between the base electrode B and the collector electrode C of the first PNP transistor 437. In addition, it comprises a resistor 34 connecting the drain electrode D of the PMOS 33 to the drain electrodes D of the NMOSs 30 and 31, and a resistor 35 connecting the base electrode B to the emitter electrode E of the second PNP transistor 436.

In this circuit, the bipolar NPN transistors 36 and 37 in the circuit of Fig. 6 are replaced by the bipolar PNP transistors 437 and 436, respectively, whereby the same operation as in the third embodiment is performed.

While a 2-input NOR circuit is described in this embodiment, this conception can also be applied to 3-input, 4-input, or generally k-input NOR circuits (k ≧ 2), to which this invention is applicable.

It will easily be understood by those skilled in the art that the embodiments of Figs. 14, 15 and 16 can be modified as the embodiments of Figs. 7 to 13.

While in the above described embodiments the logic gates are only NAND and NOR circuits, it will easily be understood that other logic gate circuits such as AND and OR circuits, logic circuit combinations, flip-flops or shift registers can be formed by connecting a logic gate circuit of, for example, CMOS transistors to the input side of the NAND and NOR circuits.

According to this invention, as described above, it is possible to produce high-speed, low-power consumption gate circuits formed of field-effect and bipolar transistors, whereby a high density integration is possible.

## Claims

1. A composite bipolar transistor-complementary field-effect transistor logic gate integrated circuit comprising:
A) a semiconductor substrate;
B) a first bipolar transistor (14, 26, 36, 125) having a collector of a first conductivity type connected to a first potential (1), an emitter of the first conductivity type connected to an output terminal (17, 29, 39), and a base of a second conductivity type;
C) a second bipolar transistor (15, 27, 37, 126) having its collector of the first conductivity type connected to the output terminal (17, 29, 39), an emitter of the first conductivity type connected to a second potential, and a base of the second conductivity type;
D) k input terminals (k ≧ 1) (16, 28, 38);
E) k field-effect transistors (10, 20, 21, 30, 31) of the second conductivity type having their gates connected to each of the input terminals (16, 28, 38), respectively, and their sources and drains connected between the base and the collector of the first bipolar transistor (14, 26, 36, 125), respectively, and
F) k field-effect transistors (11, 22, 23, 32, 33) of the first conductivity type having their gates connected to each of the input terminals (16, 28, 38), respectively, and their sources and drains connected between the base and the collector of the second bipolar transistor (15, 27, 37, 126),
characterized in that
G) first discharge means (12, 24, 34, 90) are provided connected to the base of the first bipolar transistor (14, 26, 36, 125) for discharging charges accumulated in the first bipolar transistor when the first bipolar transistor is switched from the on-state to the off-state;
H) second discharge means (13, 25, 35, 100, 110) are provided connected to the base of the second bipolar transistor (15, 27, 37, 126) for discharging from the base charges accumulated in said second bipolar transistor when said second bipolar transistor is switched from the on-state to the off-state;
I) the substrate (210) is of the second conductivity type,
J) the first and second bipolar transistors (14, 15, 26, 27, 36, 37, 125, 126) are each of a vertical type formed respectively in semiconductor regions (212, 213) of the first conductivity type isolated from one another by means of the semiconductor substrate (210), and
K) the base regions (225, 217) of the first and second bipolar transistors (14, 15, 26, 27, 36, 37, 125, 126) are isolated from the source, drain and channel regions of the field-effect transistors (10, 11, 20, 21, 22, 23, 30, 31, 32, 33).

2. A logic gate circuit according to claim 1,
characterized in that
the first and second bipolar transistors (14, 15) are formed in a first and a second semiconductor region (212, 213) of the first conductivity type isolated from one another and from a semiconductor substrate region (210) of the second conductivity type,
the k first field-effect transistors (10) are formed in a third semiconductor region (212) of the first conductivity type isolated from the semiconductor substrate region (210) of the second conductivity type,
the k second field-effect transistors (11) are formed in a fourth semiconductor region (214) of the second conductivity type isolated from the second bipolar transistor (15), and
the first and second discharge means (12, 13) are formed in a fifth and a sixth region (P) isolated from one another and from the base regions (225, 217).

3. A logic gate circuit according to claim 1,
characterized in that
the first discharge means are discharge means for discharging accumulated charges from the first bipolar transistor and at least one of the k field-effect transistors of the second conductivity type to the second potential, when said first bipolar transistor and said at least one of k field-effect transistors of the second conductivity type are switched from the on-state to the off-state, and
the second discharge means are discharge means for discharging accumulated charges from the second bipolar transistor and at least one of said k field-effect transistors of the first conductivity type to the second potential, when the second bipolar transistor and said at least one of k field-effect transistors of the first conductivity type are switched from the on-state to the off-state.

4. A logic gate circuit according to claim 1,
characterized in that
the distance between the k first field-effect transistors (10) and the first bipolar transistor (14) is shorter than the distance between the k second field-effect transistors (11) and the first bipolar transistor (14), and the distance between the k second field-effect transistors (11) and the second bipolar transistor (15) is shorter than the distance between the k first field-effect transistors (10) and the second bipolar transistor (15).

5. A logic gate circuit according to claim 1,
characterized by
first connection means connected between the first collector electrode, the first source electrode and a first potential terminal (V_{DD}),
second connection means connected between the first base electrode, the first drain electrode and the first discharge electrode,
third connection means connected between the first emitter electrode, the second collector electrode, the second drain electrode and an output terminal (OUT),
fourth connection means connected between the second base electrode, the second source electrode and the third discharge electrode,
fifth connection means connected between the second emitter electrode and a second potential terminal (GND),
sixth connection means connected between the first gate electrode, the second gate electrode and an input terminal (IN),
seventh connection means connected between the second discharge electrode and a first discharge potential point, and
eighth connection means connected between the fourth discharge electrode and a second discharge potential point (GND).

6. A logic gate circuit according to claim 1,
characterized in that
at least one third field-effect transistor (123) of the first conductivity type having its gate connected to the input terminal (16) and its drain and source respectively connected to the first fixed potential (1) and the base of the second bipolar transistor (15; 27; 37; 126).

## Patentansprüche

1. Integrierte Schaltung eines Logik-Gatters mit Bipolartransistor und Komplementär-Feldeffekt-Transistor, umfassend:
A) Halbleitersubstrat;
B) ersten Bipolartransistor (14, 26, 36, 125), bei dem der Kollektor von einem ersten Leitfähigkeitstyp auf einem ersten Potential (1) liegt, der Emitter vom ersten Leitfähigkeitstyp mit dem Ausgang (17, 29, 39) verbunden ist und die Basis vom zweiten Leitfähigkeitstyp ist;
C) zweiten Bipolartransistor (15, 27, 37, 126), dessen Kollektor vom ersten Leitfähigkeitstyp mit dem Ausgang (17, 29, 39) verbunden ist, dessen Emitter vom ersten Leitfähigkeitstyp auf einem zweiten Potential liegt und dessen Basis vom zweiten Leitfähigkeitstyp ist;
D) k Eingänge (k ≧ 1) (16, 28, 38);
E) k Feldeffekttransistoren (10, 20, 21, 30, 31) vom zweiten Leitfähigkeitstyp, deren Gate jeweils mit den Eingängen (16, 28, 38) verbunden ist und deren Source und Drain jeweils zwischen der Basis und dem Kollektor des ersten Bipolartransistors (14, 26, 36, 125) liegen, und
F) k Feldeffekttransistoren (11, 22, 23, 32, 33) vom ersten Leitfähigkeitstyp, deren Gate jeweils mit den Eingängen (16, 28, 38) verbunden ist und deren Source und Drain jeweils mit Basis und Kollektor des zweiten Bipolartransistors (15, 27, 37, 126) verbunden sind,
dadurch gekennzeichnet, daß
G) erste Entladungsvorrichtungen (12, 24, 34, 90) vorgesehen sind, die mit der Basis des ersten Bipolartransistors (14, 26, 36, 125) für die Entladung der in dem ersten Bipolartransistor gespeicherten Ladungen verbunden sind, wenn der erste Bipolartransistor vom Ein- in den Aus-Zustand umgeschaltet wird;
H) zweite Entladungsvorrichtungen (13, 25, 35, 100, 110) vorgesehen sind, die mit der Basis des zweiten Bipolartransistors (15, 27, 37, 126) für die Entladung der in der Basis des zweiten Bipolartransistors gespeicherten Ladungen verbunden sind, wenn der zweite Bipolartransistor vom Ein- in den Aus-Zustand umgeschaltet wird;
I) das Substrat (210) vom zweiten Leitfähigkeitstyp ist,
J) die ersten und zweiten Bipolartransistoren (14, 15, 26, 27, 36, 37, 125, 126) jeweils als vertikaler Typ im Halbleiterbereich (212, 213) vom ersten Leitfähigkeitstyp aufgebaut sind und jeweils durch das Halbleitersubstrat (210) voneinander getrennt sind und
K) die Basisbereiche (225, 217) der ersten und zweiten Bipolartransistoren (14, 15, 26, 27, 36, 37, 125, 126) von Source, Drain und Kanalbereichen der Feldeffekttransistoren (10, 11, 20, 21, 22, 23, 30, 31, 32, 33) isoliert sind.

2. Logikgatterschaltung nach Anspruch 1,
dadurch gekennzeichnet, daß
die ersten und zweiten Bipolartransistoren (14, 15) in einem ersten und einem zweiten Halbleiterbereich (212, 213) vom ersten Leitfähigkeitstyp isoliert voneinander und isoliert von dem Halbleitersubstratbereich (210) des zweiten Leitfähigkeitstyps angeordnet sind,
die k ersten Feldeffekttransistoren (10) in einem dritten Halbleiterbereich (212) vom ersten Leitfähigkeitstyp isoliert von dem Halbleitersubstratbereich (210) vom zweiten Leitfähigkeitstyp angeordnet sind,
die k zweiten Feldeffekttransistoren (11) in einem vierten Halbleiterbereich (214) vom zweiten Leitfähigkeitstyp isoliert vom zweiten Bipolartransistor (15) angeordnet sind und
die erste und zweite Entladungsvorrichtung (12, 13) in einem fünften und einem sechsten Bereich (P) isoliert voneinander und isoliert vom Basisbereich (225, 217) angeordnet sind.

3. Logikgatterschaltung nach Anspruch 1,
dadurch gekennzeichnet, daß
die ersten Entladungsvorrichtungen Entladungsvorrichtungen für die Entladung der gespeicherten Ladungen im ersten Bipolartransistor und wenigstens einem der k Feldeffekttransistoren vom zweiten Leitfähigkeitstyp gegenüber dem zweiten Potential sind, wenn der erste Bipolartransistor und wenigstens einer der k Feldeffekttransistoren vom zweiten Leitfähigkeitstyp vom Ein- in den Aus-Zustand umgeschaltet werden, und
die zweiten Entladungsvorrichtungen Entladungsvorrichtungen für die Entladung der gespeicherten Ladungen im zweiten Bipolartransistor und wenigstens einem der k Feldeffekttransistoren vom ersten Leitfähigkeitstyp gegenüber dem zweiten Potential sind, wenn der zweite Bipolartransistor und wenigstens einer der k Feldeffekttransistoren vom ersten Leitfähigkeitstyp vom Ein- in den Aus-Zustand geschaltet werden.

4. Logikgatterschaltung nach Anspruch 1,
dadurch gekennzeichnet, daß
die Entfernung zwischen den k ersten Feldeffekttransistoren (10) und dem ersten Bipolartransistor (14) kürzer als der Abstand zwischen den k zweiten Feldeffekttransistoren (11) und dem ersten Bipolartransistor (14) ist und der Abstand zwischen den k zweiten Feldeffekttransistoren (11) und dem zweiten Bipolartransistor (15) kleiner als der Abstand zwischen den k ersten Feldeffekttransistoren (10) und den zweiten Bipolartransistoren (15) ist.

5. Logikgatterschaltung nach Anspruch 1,
gekennzeichnet durch
erste Verbindungsvorrichtung, die zwischen der ersten Kollektorelektrode, der ersten Source-Elektrode und einem ersten Potentialanschluß (V_{DD}) liegt,
zweite Verbindungsvorrichtung, die zwischen der ersten Basiselektrode, der ersten Drain-Elektrode und der ersten Entladungselektrode liegt,
dritte Verbindungsvorrichtung, die zwischen der ersten Emitterelektrode, der zweiten Kollektorelektrode, der zweiten Drain-Elektrode und einem Ausgangsanschluß (OUT) liegt,
vierte Verbindungsvorrichtung, die zwischen der zweiten Basiselektrode, der zweiten Source-Elektrode und der dritten Entladungselektrode liegt,
fünfte Verbindungsvorrichtung, die zwischen der zweiten Emitterelektrode und einem zweiten Potentialanschluß (GND) liegt,
sechste Verbindungsvorrichtung, die zwischen der ersten Gate-Elektrode, der zweiten Gate-Elektrode und einem Eingangsanschluß (IN) liegt,
siebte Verbindungsvorrichtung, die zwischen der zweiten Entladungselektrode und einem ersten Entladungspotentialpunkt liegt und
achte Verbindungsvorrichtung, die zwischen der vierten Entladungselektrode und einem zweiten EntladungsPotentialpunkt (GND) liegt.

6. Logikgatterschaltung nach Anspruch 1,
dadurch gekennzeichnet, daß
bei wenigstens einem Drittel der Feldeffekttransistoren (123) vom ersten Leitfähigkeitstyp das Gate mit dem Eingangsanschluß (16) und Drainb und Source jeweils mit dem ersten festen Potential (1) und der Basis des zweiten Bipolartransistors (15, 27, 37, 126) verbunden ist.

## Revendications

1. Circuit intégré formant porte logique composite à transistors bipolaires et transistors à effet de champ complémentaires, comprenant :
A) un substrat semiconducteur;
B) un premier transistor bipolaire (14,26,36,125) possédant un collecteur ayant un premier type de conductivité et raccordé à un premier potentiel (1), un émetteur possédant le premier type de conductivité et raccordé à une borne de sortie (17,29,39) et une base possédant un second type de conductivité;
C) un second transistor bipolaire (15,27,37,126) dont le collecteur, qui possède le premier type de conductivité, est raccordé à la borne de sortie (17,29,39), un émetteur possédant le premier type de conductivité et raccordé à un second potentiel, et une base possédant le second type de conductivité;
D) k bornes d'entrée (k ≧ 1) (16,28,38);
E) k transistors à effet de champ (10,20,21,30,31) possédant le second type de conductivité, dont les grilles sont raccordées respectivement aux diverses bornes d'entrée (16,28,38) et dont les sources et les drains sont branchés respectivement entre la base et le collecteur du premier transistor bipolaire (14,26,36,125), et
F) k transistors à effet de champ (11,22,23,32,33) possédant le premier type de conductivité et dont les grilles sont raccordées respectivement aux diverses bornes d'entrée (16,26,38) et dont les sources et les drains sont branchés entre la base et le collecteur du second transistor bipolaire (15,27,37, 126);
caractérisé en ce que
G) il est prévu des premiers moyens de décharge (12,24,34,90), qui sont raccordés à la base du premier transistor bipolaire (14,26,36,125) pour décharger des charges accumulées dans le premier transistor bipolaire lorsque le premier transistor bipolaire est commuté de l'état conducteur à l'état bloqué;
H) il est prévu des seconds moyens de décharge (13,25,35,100,110) raccordés à la base du second transistor bipolaire (15,27,37,126) pour décharger à partir de la base, des charges accumulées dans ledit second transistor bipolaire lorsque ledit second transistor bipolaire est commuté de l'état conducteur à l'état bloqué;
I) le substrat (210) possède le second type de conductivité,
J) les premier et second transistors bipolaires (14,15,26,27,36,37,125,126) sont tous les deux d'un type vertical formé respectivement dans les régions semiconductrices (212, 213) possédant le premier type de conductivité et isolées l'une de l'autre par le substrat semiconducteur (210), et
K) les régions de base (225,217) des premier et second transistors bipolaires (14,15,26,27,36,37,125,126) sont isolées des régions de source, de drain et de canal des transistors à effet de champ (10,11,20,21,22,23,30,31,32,33).

2. Circuit formant porte logique selon la revendication 1, caractérisé en ce que
les premier et second transistors bipolaires (14,15) sont formés dans des première et seconde régions semiconductrices (212,213) possédant le premier type de conductivité et isolées l'une de l'autre et vis-à-vis de la région (210) du substrat semiconducteur, qui possède le second type de conductivité,
les k premiers transistors à effet de champ (10) sont formés dans une troisième région semiconductrice (212) possédant le premier type de conductivité et qui est isolée vis-à-vis de la région (210) du substrat semiconducteur, qui possède le second type de conductivité,
les k seconds transistors à effet de champ (11) sont formés dans une quatrième région semiconductrice (214) possédant un second type de conductivité et qui est isolée vis-à-vis du second transistor bipolaire (15), et
les premier et second moyens de décharge (12,13) sont formés dans des cinquième et sixième régions (P) isolées l'une de l'autre et vis-à-vis des régions de base (225,217).

3. Circuit formant porte logique selon la revendication 1, caractérisé en ce que
les premiers moyens de décharge sont des moyens de décharge servant à décharger des charges accumulées, à partir du premier transistor bipolaire et d'au moins l'un des k transistors à effet de champ possédant le second type de conductivité, vers le second potentiel, et ledit au moins un transistor faisant partie des k transistors à effet de champ possédant le second type de conductivité est commuté de l'état conducteur à l'état bloqué, et
les seconds moyens de décharge sont des moyens de décharge servant à décharger des charges accumulées à partir du second transistor bipolaire et d'au moins l'un desdits k transistors à effet de champ possédant le premier type de conductivité en direction du second potentiel, lorsque le second transistor bipolaire et ledit au moins un des k transistors à effet de champ possédant le premier type de conductivité sont commutés de l'état conducteur à l'état bloqué.

4. Circuit formant porte logique selon la revendication 1, caractérisé en ce que
la distance entre les k premiers transistors à effet de champ (10) et le premier transistor bipolaire (14) est inférieure à la distance entre les k seconds transistors à effet de champ (11) et le premier transistor bipolaire (14), et la distance entre les k seconds transistors à effet de champ (11) et le second transistor bipolaire (15) est inférieure à la distance entre les k premiers transistors à effet de champ (10) et le second transistor bipolaire (15).

5. Circuit formant porte logique selon la revendication 1, caractérisé par
des premiers moyens de connexion branchés entre la première électrode de collecteur, la première électrode de source et une première borne de potentiel (V_{DD}),
des seconds moyens de connexion branchés entre la première électrode de base, la première électrode de drain et la première électrode de décharge,
des troisièmes moyens de connexion branchés entre la première électrode d'émetteur, la seconde électrode d'émetteur, la seconde électrode de drain et une borne de sortie (OUT),
des quatrièmes moyens de connexion branchés entre la seconde électrode de base, la seconde électrode de source et la troisième électrode de décharge,
des cinquièmes moyens de connexion branchés entre la seconde électrode d'émetteur et une seconde borne de potentiel (GND),
des sixièmes moyens de connexion branchés entre la première électrode de porte, la seconde électrode de porte et une borne d'entrée (IN),
des septièmes moyens de connexion branchés entre la seconde électrode de décharge et un premier point de potentiel de décharge, et
des huitièmes moyens de connexion branchés entre la quatrième électrode de décharge et un second point de potentiel de décharge (GND).

6. Circuit formant porte logique selon la revendication 1, caractérisé en ce qu'il est prévu au moins un troisième transistor à effet de champ (123) possédant le premier type de conductivité et dont la grille est raccordée à la borne d'entrée (16) et le drain et la source sont raccordés respectivement au premier potentiel fixe (1) et à la base du second transistor bipolaire (15;27;37;126).
